# EUROPEAN PATENT APPLICATION

(11) **EP 4 636 479 A1**
(43) Date of publication of application: **22.10.2025**
(21) Application number: 24170719.9
(22) Date of filing: 17.04.2024
(51) Int. Cl.: G03F 7/00, H05G 2/00

(54) **RADIATION SOURCE HOUSING AND COLLECTOR**

(71) Applicant: ASML Netherlands B.V., 5500 AH Veldhoven (NL)
(72) Inventor: KOCKEROLS, Jean, 5500AH Veldhoven (NL); HARRISON, Kramer, Daniel, 5500AH Veldhoven (NL); UTINA, Andrei, Catalin, 5500AH Veldhoven (NL); SUBKHANGULOV, Ruslan Rifovich, 5500AH Veldhoven (NL); CORONEL, Joshua, 5500AH Veldhoven (NL); JURNA, Martin, 5500AH Veldhoven (NL)
(74) Representative: ASML Netherlands B.V.

(57) **Abstract**

A radiation source comprising a source of target material configured to direct target material to a plasma formation location, and a laser system configured to direct an infrared laser beam onto the target material at the plasma formation location to generate EUV radiation, wherein the radiation source further comprises a housing with an opening through which EUV radiation may exit the radiation source, wherein the radiation source is configured such that a first portion of the housing receives a majority of the infrared radiation beam when the infrared radiation beam is not incident upon a target material, and wherein the first portion of the housing is configured to reflect the infrared radiation to other portions of the housing which are further away from the opening of the housing.

## Description

### FIELD

The present invention relates to a radiation source housing and collector, and to a radiation source.

### BACKGROUND

Light generated by means of a radiation source can be used by exposure apparatuses for semiconductor manufacturing processes. Examples of such exposure apparatuses are a lithographic apparatus, a metrology, or an inspection apparatus, more specifically a mask inspection apparatus and even more specifically an actinic mask inspection apparatus.

A lithographic apparatus is a machine constructed to apply a desired pattern onto a substrate. A lithographic apparatus can be used, for example, in the manufacture of integrated circuits (ICs). A lithographic apparatus may, for example, project a pattern at a patterning device (e.g., a mask) onto a layer of radiation-sensitive material (e.g., a photoresist or resist) provided on a substrate. To project a pattern on a substrate a lithographic apparatus may use electromagnetic radiation. The wavelength of this radiation determines the minimum size of features which can be formed on the substrate. A lithographic apparatus, which uses EUV radiation, having a wavelength within the range 4-20 nm, for example 6.7 nm or 13.5 nm, may be used to form smaller features on a substrate than a lithographic apparatus which uses, for example, radiation with a wavelength of 193 nm.

An (actinic) mask inspection apparatus is an apparatus that is configured for measuring dimensions or detecting defects in masks or mask blanks. EUV lithography uses reflective mirrors instead of lenses as optics. Mask blanks used in EUV lithography generally have a multilayer structure which functions as a Bragg reflector. The multilayers may be alternatingly Molybdenum and Silicon. If a defect exists in this structure, the projected pattern will be deformed in the lithographic process. Therefore, mask inspection to check whether a defect is present is considered a requirement for a mass-production process. EUV mask inspection may be used for several purposes and in several different stages. Firstly, it can be used for the detection of phase defects that may occur in mask blanks. Such phase defects may occur during the manufacturing of the multilayer stack of the mask blank. If undetected, these phase defects are printed on all chips printed with the part of a mask containing the phase defects. Such phase defects may be correctly detected by using the same or similar (13.5nm) actinic EUV wavelength as the lithography tool. Secondly, mask inspection can be used for patterned mask inspection and can be carried out for the quality control of EUV patterned masks. For example, the mask inspection can be used to measure critical dimensions on the mask blank. In addition to phase defects, absorber pattern defects on the surface can be detected. Thirdly, mask inspection can be used for simulating exposure and determining the deterioration of optical contrast of a defect detected in the actinic inspection. Fourthly, the mask inspection can be used for optical proximity correction (OPC) evaluation or during mask repair process so as to improve pattern transfer fidelity. Further, it can be used for inspecting optical contrast after fixing the defect. In addition to the above, mask inspection can also be used to measure small particle/amplitude effects.

EUV radiation may be produced by a laser produced plasma (LPP) radiation source. Within an LPP radiation source, a laser beam may be used to irradiate a target material, e.g. in the form of fuel droplets (e.g. tin) so as to produce a plasma which will emit EUV radiation. An alternative radiation source may be used to generate EUV radiation. In the alternative radiation source, a laser beam may be used to irradiate a target material (e.g. tin) provided on a rotating element (e.g. a wheel, cylinder or drum) to produce a plasma which will emit EUV radiation. In both forms of radiation source, the laser beam may be an infrared radiation beam. A collector may be used to collect EUV radiation emitted from the plasma and direct the EUV radiation out of the radiation source.

The infrared laser beam may cause undesirable heating of the radiation source. In addition, some infrared radiation may escape out of the radiation source in an undesirable manner.

It may be desirable to provide a radiation source housing and collector and/or a radiation source which is not disclosed or suggested by the prior art.

### SUMMARY

According to a first aspect of the invention there is provided a radiation source comprising a source of target material configured to direct target material to a plasma formation location, and a laser system configured to direct an infrared laser beam onto the target material at the plasma formation location to generate EUV radiation, wherein the radiation source further comprises a housing with an opening through which EUV radiation may exit the radiation source, wherein the radiation source is configured such that a first portion of the housing receives a majority of the infrared radiation beam when the infrared radiation beam is not incident upon a target material, and wherein the first portion of the housing is configured to reflect the infrared radiation to other portions of the housing which are further away from the opening of the housing.

Advantageously, because the first portion of the housing is configured to reflect the infrared radiation, it is heated less by the infrared radiation than the other portions of the housing. These other portions may be easier to cool than the first portion of the housing.

The first portion of the housing may be configured to receive substantially all of the infrared radiation beam when the infrared radiation beam is not incident upon a target material.

The first portion of the housing may comprise a series of annular steps which comprise an inwardly tapering portion and an outwardly tapering portion.

The inwardly tapering portion may subtend an angle of between 10° and 30° relative to a plane which is perpendicular to an optical axis of the radiation source.

The outwardly tapering portion may subtend an angle of between 3° and 9° relative to an optical axis of the radiation source.

The annular steps may be generally equal in size.

The first portion of the housing has a surface roughness which is less than the surface roughness of other portions of the housing.

According to a second aspect of the invention there is provided a radiation source housing and collector, the collector being configured to collect EUV radiation emitted from a plasma formation location and direct the EUV radiation to an opening of the housing, wherein the collector is configured to receive infrared radiation from the plasma formation location and diffract the infrared radiation towards a diffracted radiation receiving portion of the housing, and wherein the diffracted radiation receiving portion of the housing comprises a series of irregularly spaced annular recesses.

The irregularly annular spaced annular recesses of the diffracted radiation receiving portion of the housing may each be configured to receive different orders of diffracted infrared radiation, and to reflect the diffracted infrared radiation away from the opening of the housing.

At least one of the annular recesses may comprise a roof portion which extends in a generally radial direction relative to an optical axis of the radiation source.

The annular recesses may further comprise an outwardly tapering wall portion.

The non-recessed wall portion may extend between adjacent annular recesses.

The diffracted radiation receiving portion of the housing may have a surface roughness which is less than the surface roughness of other portions of the housing.

A radiation source according to the first aspect and further comprising the radiation source housing and collector according to the second aspect, wherein the diffracted radiation receiving portion of the housing forms part of the first portion of the housing.

A portion of the housing which is further away from the exit opening than the diffracted radiation receiving portion of the housing may have a rougher surface than the diffracted radiation receiving portion.

The radiation source may be frustoconical.

The radiation source may further comprise a source of target material configured to direct target material to the plasma formation location, and a laser system configured to direct a laser beam onto the target material at the plasma formation location.

According to a third aspect of the invention there is provided an exposure apparatus comprising the radiation source of the second aspect of the invention, and further comprising in an illumination system configured to receive EUV radiation which passes out of the opening of the radiation source housing, and further comprising a projection system configured to project patterned EUV radiation onto a substrate.

According to a fourth aspect of the invention there is provided a method of manufacturing/forming a semiconductor device comprising the steps of receiving a substrate with a photoresist layer, directing onto the substrate radiation from a radiation source according to the first aspect of the invention or a radiation source comprising the housing and collector according to the second aspect of the invention, to transfer a pattern from a mask onto the photoresist layer, and removing a portion of the photoresist layer to form the pattern over the substrate.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a lithographic system comprising a lithographic apparatus and further comprising a radiation source according to an embodiment of the invention;
- Figure 2 schematically depicts a system for (actinic) mask inspection which comprises a radiation source according to an embodiment of the invention;
- Figures 3A and 3B schematically depict a radiation source according to an embodiment of the invention in an off-droplet situation and an on-droplet situation;
- Figure 4 schematically depicts part of a diffraction grating of a collector which may form part of an embodiment of the invention;
- Figure 5 depicts part of a radiation source housing according to an embodiment of the invention;
- Figures 6A and 6B depict reflection of infrared radiation from the housing in an on-droplet situation;
- Figures 7A and 7B depict reflection of infrared radiation from the housing in an on-droplet situation; and
- Figure 8 depicts part of a radiation source housing according to another embodiment of the invention.

### DETAILED DESCRIPTION

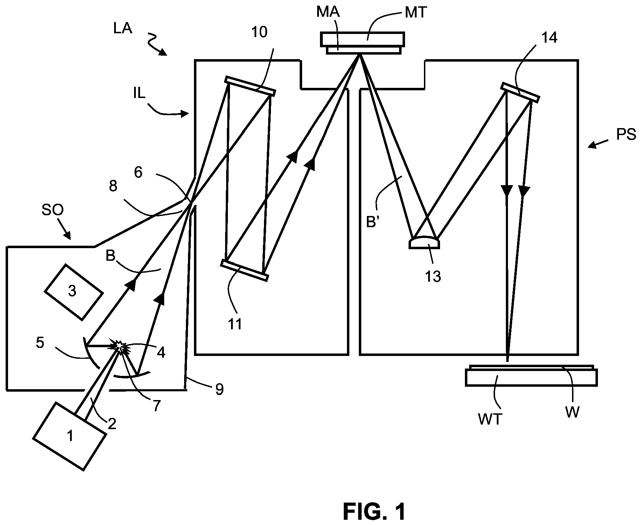

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate W.

The illumination system IL is configured to condition the EUV radiation beam B before the EUV radiation beam B is incident upon the patterning device MA. Thereto, the illumination system IL may include a faceted field mirror device 10 and a faceted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate W. For that purpose, the projection system PS may comprise a plurality of mirrors 13,14 which are configured to project the patterned EUV radiation beam B' onto the substrate W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g., six or eight mirrors).

The substrate W may include previously formed patterns. Where this is the case, the lithographic apparatus LA aligns the image, formed by the patterned EUV radiation beam B', with a pattern previously formed on the substrate W.

A relative vacuum, i.e. a small amount of gas (e.g. hydrogen) at a pressure well below atmospheric pressure, may be provided in the radiation source SO, in the illumination system IL, and/or in the projection system PS.

The lithographic apparatus LA and radiation source SO described herein can be used in method for performing a circuit layout patterning process. A circuit layout patterning method comprises receiving a substrate with a photoresist layer. The method further comprises directing EUV radiation from radiation source to the photoresist layer to form a patterned photoresist layer. The method further comprises developing and etching the patterned photoresist layer to form a circuit layout.

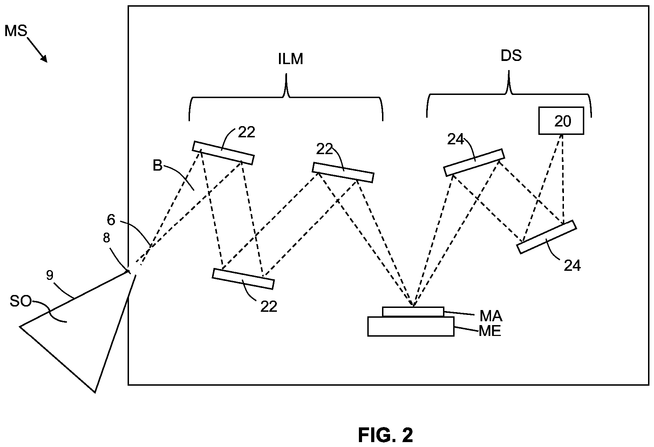

Figure 2 schematically depicts a system MS for (actinic) mask inspection. The mask inspection system MS can be used to identify or inspect defects in a mask to be used in a lithographic process by means of the lithographic apparatus described in figure 1. The mask inspection system MS comprises a radiation source SO, an illumination system ILM, a detection system DS and a mask stage ME.

The illumination system ILM is configured to condition an EUV radiation beam B before the EUV radiation beam B is incident upon the mask MA. The illumination system ILM may provide the EUV radiation beam B with a desired cross-sectional shape and a desired intensity distribution. The illumination system ILM may comprise a plurality of mirrors 22. The illumination system ILM may comprise one or more faceted mirror devices.

The mask stage ME may be configured to move the mask MA relative to the EUV radiation beam B, so that the EUV radiation beam is incident upon different areas of the mask.

The detection system DS comprises a detector 20, and may in addition comprise a plurality of mirrors 24. The plurality of mirrors 24 may be configured to collect EUV radiation BR that has been reflected from the mask MA, and form an image of the mask MA on the detector 20 (which may be an imaging array). A processor (not depicted) may receive signals output from the detector 20 and use those signals to look for defects in the mask MA.

The radiation source SO shown in Figures 1 and 2 is, for example, of a type which may be referred to as a laser produced plasma (LPP) source. A laser system 1 is arranged to deposit energy via a laser beam 2 into a fuel (i.e., a target material), such as tin (Sn) which is provided from, e.g., a target supply system 3. Although tin is referred to in the following description, any suitable fuel may be used. The fuel may, for example, be in liquid form, and may, for example, be a metal or alloy. The fuel may be referred to as a target material. The target supply system 3 may comprise a nozzle configured to direct the fuel, e.g. in the form of droplets, along a trajectory towards a plasma formation region 4. The laser beam 2 is incident upon the fuel at the plasma formation region 4. The deposition of laser energy into the tin creates a plasma 7 at the plasma formation region 4. Radiation, including EUV radiation, is emitted from the plasma 7 during de-excitation and recombination of electrons with ions of the plasma 7.

The EUV radiation from the plasma 7 is collected and focused by a collector 5. Collector 5 comprises, for example, a near-normal incidence radiation collector 5 (sometimes referred to more generally as a normal-incidence radiation collector). The collector 5 may have a multilayer mirror structure which is arranged to reflect EUV radiation (e.g., EUV radiation having a desired wavelength such as 13.5 nm). The collector 5 may have an ellipsoidal configuration, having two focal points. A first one of the focal points may be at the plasma formation region 4, and a second one of the focal points may be at an intermediate focus 6, as discussed below.

The laser system 1 may be spatially separated from the radiation source SO. Where this is the case, the laser beam 2 may be passed from the laser system 1 to the radiation source SO with the aid of a beam delivery system (not shown) comprising, for example, suitable directing mirrors and/or a beam expander, and/or other optics. The laser system 1, the radiation source SO and the beam delivery system (if present) may together be considered to be a radiation system.

Radiation that is reflected by the collector 5 forms the EUV radiation beam B. The EUV radiation beam B is focused at intermediate focus 6 to form an image at the intermediate focus 6 of the plasma present at the plasma formation region 4. The image at the intermediate focus 6 acts as a virtual radiation source for the illumination system IL. The radiation source SO is arranged such that the intermediate focus 6 is located at or near to an opening 8 in an enclosing structure 9 of the radiation source SO. The enclosing structure may be referred to as a housing 9.

The radiation source SO of the mask inspection system MS may correspond with the radiation source SO depicted in Figure 1. In the same way as depicted in Figure 1, the radiation source SO of the mask inspection system MS may focus the EUV radiation beam B to form an intermediate focus 6.

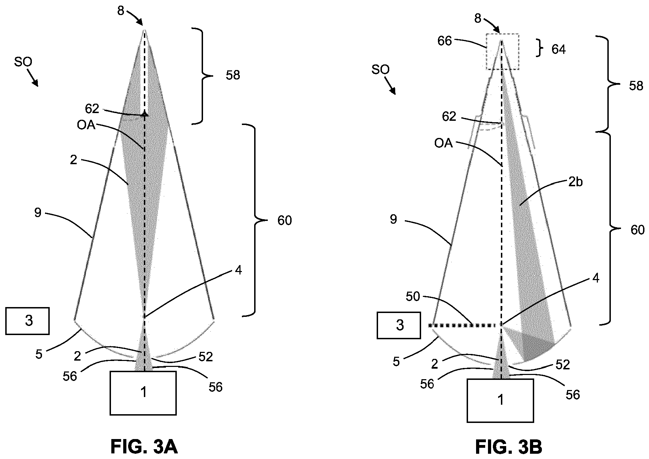

Figures 3A and 3B schematically depict a radiation source SO according to an embodiment of the invention. The radiation source SO comprises a laser system 1 configured to provide a laser beam 2. The laser system 1 includes optics (not depicted) which are configured to focus the laser beam 2 at a plasma formation region 4 of the radiation source. A target supply system 3 is configured to provide target material, for example in the form of fuel droplets 50 (see Figure 3B) to the plasma formation region 4. In Figure 3A the target supply system 3 is not providing fuel. The fuel may be tin.

The radiation source SO further comprises a collector 5. The collector 5, and other parts of the radiation source SO may be as described further above in connection with Figure 1. An entrance opening 52 is provided in the collector 5. The entrance opening 52 is dimensioned to allow the laser beam 2 to pass through the entrance opening and be incident at the plasma formation region 4. Radiation source 4 further comprises an exit opening 8 at an opposite end from the entrance opening 52. The laser beam 2 may be infrared, e.g. with a wavelength of around 10 microns, or with a wavelength of around 2 microns.

The radiation source SO includes a housing 9. In the depicted embodiment the housing 9 is generally frustoconical. However, the housing 9 may have other shapes. In general the housing 9 may taper inwardly towards the exit opening 8.

The housing 9 includes different portions which are configured to receive and reflect the laser beam 2 in a desired manner.

Referring first to Figure 3A, the situation is shown in which a target material is not present at the plasma formation region 4. This may occur for example if it is desired to reduce a power of EUV radiation incident upon a substrate being exposed, by not generating EUV radiation using some target material. In Figure 3A the laser beam 2 is schematically depicted as a beam which includes outer edges 56. The laser beam 2 is focused and thus converges at the plasma formation region 4. After the plasma formation region 4 the laser beam 2 diverges as is schematically depicted. The divergence of the laser beam 2 is limited, and as a result the laser beam 2 is only incident at a distal portion 58 of the housing 9. This distal portion 58 may be referred to as the directly incident infrared portion 58 (because it is a portion which receives infrared radiation 2 that has not been reflected within the housing 9 of the radiation source SO). The laser beam 2 is not directly incident upon a proximal portion 60 of the housing 9. The distal portion 58 of the housing 9 may be referred to as the first portion. The first portion 58 may receive substantially all of the directly incident infrared radiation. The first portion 58 may receive a majority of the directly incident infrared radiation.

The distal portion 58 of the housing 9 is configured to reflect the laser beam 2 towards the proximal portion 60 of the housing. The configuration of the distal portion 58 of the housing 9 which provides this reflection is described further below.

The laser beam 2 is not directly incident upon the proximal portion 60 of the housing, 9 but is incident upon the proximal portion of the housing after reflection from the distal portion 58. The proximal portion 60 of the housing 9 is configured to absorb this reflected laser radiation. The proximal portion 60 may be referred to as the infrared radiation absorbing portion 60. As noted further above the laser radiation may be infrared.

A bar 62 extends across the radiation source housing 9 and intersects with the optical axis OA of the laser beam 2 (which is also the optical axis of the radiation source SO). The bar 62 extends into and out of the plane of the figure. The bar 62 prevents a central portion of the laser beam 2 from passing directly out of the exit opening 8.

The situation depicted in Figure 3A may be referred to as off-droplet because the laser beam is not incident upon a target material (which may be a fuel droplet).

Figure 3B schematically depicts the situation in which the infrared laser beam 2 is incident upon a target material 50 at the plasma formation region 4. The target material 50 may have some reflectivity for infrared. Eventually, the infrared laser beam 2 will burn through the target material 50 (e.g. tin droplet) and convert the target material to an EUV radiation emitting plasma. However, this process takes some time, and in the interim some of the infrared laser beam 2 is reflected from the target material 50. A portion of this reflection is schematically depicted in Figure 3B.

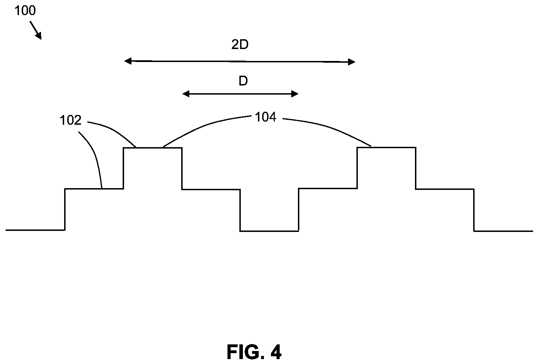

The collector 5 is provided with a diffraction grating structure which is configured to diffract infrared radiation. An example of the diffraction grating structure is schematically depicted in Figure 4. The diffraction grating structure forms diffraction orders from the infrared radiation. These diffraction orders of infrared radiation are incident at the distal portion 58 of the housing 9. The distal portion 58 of the housing 9 includes a diffracted radiation receiving portion 64. The position of the plasma formation region 4, where the laser beam 2 will be reflected from a target material 50 is known, and thus the angles of incidence on the collector 5 of the reflected laser beam are known. The wavelength of the infrared laser beam 2 is known (e.g. around 10 microns). As a result, the diffraction grating structure on the collector 5 will provide diffraction orders which are incident at known locations at the diffracted radiation receiving portion 64 of the housing 9. A first diffraction order, a third diffraction order, and potentially a '½' diffraction order may be incident at the diffracted radiation receiving portion 64. Other diffraction orders may also be incident at the diffracted radiation receiving portion 64. In Figure 3B, diffracted radiation is depicted as a single beam 2b. In practice, the diffracted radiation 2b may have an annular form, and thus may be incident as a ring of radiation which extends around the diffracted radiation receiving portion 64. Different diffraction orders may be incident as rings of radiation which extend around the diffracted radiation receiving portion 64 at different distances from the exit opening 8.

Figure 3B depicts what may be referred to as an 'on-droplet' situation because the laser beam 2 is incident upon a target material 50 (which may be a fuel droplet).

Figure 4 schematically depicts part of the diffraction grating structure 100 provided on the collector 5. The diffraction grating structure comprises steps which extend as rings around the entrance opening 52 of the collector. Some of these steps 102 are depicted in Figure 4. Each step 102 extends in a circumferential direction. A dimension D of one step unit is selected to provide strong diffraction of the incident infrared radiation. In an example, the infrared radiation has a wavelength of around 10 microns, and the dimension D is 1 mm. In another example, the infrared radiation may have a wavelength of around 2 microns, with the dimension D being 0.2 mm. Providing a diffraction grating with a unit dimension which is around 100x the wavelength of radiation to be diffracted will provide diffraction orders having the same diffraction angles.. In general, the dimension D may be selected to provide diffraction orders which are incident at desired locations in the housing 9. The dimension D may be chosen to provide desired diffraction angles using the grating equation Sin(θ)=N*wavelength/D, where θ is he diffraction angle, N is the diffraction order and D is the unit dimension of the diffraction grating.

The diffraction grating structure 100 does not consist of a simple step-up then step-down structure. Instead, there are two steps up and two steps down. As a result there is a separation of twice the unit step D between adjacent uppermost steps 104 (i.e. a separation of 2D). This provides an additional diffraction order. The additional diffraction order may be referred to as the ½ order because it is diffracted at an angle which is ½ the diffraction angle of the first order generated by the overall step size D.

The diffraction grating structure 100 may be referred to as a binary grating with three levels.

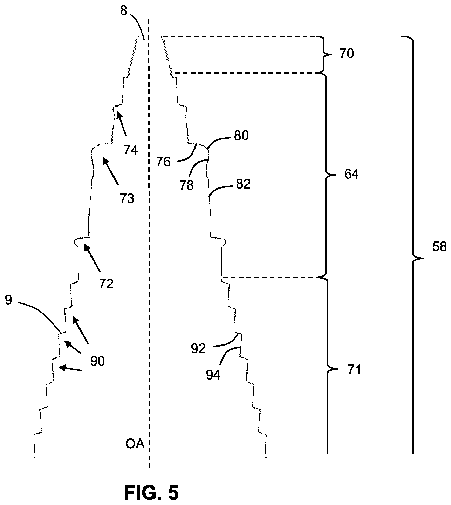

Part of the direct radiation receiving portion 58 of the housing 9 (also referred to as the first portion 58) is depicted in cross section in Figure 5. This part is the part that is identified using a box 66 formed from dashed lines in Figure 3B. This includes the diffracted radiation receiving portion 64 of the housing 9 (also referred to as the second portion 64). A tip portion 70 of the housing 9 is also depicted. As may be understood from Figure 3B, the direct infrared receiving portion 58 extends beyond the bottom of the part 66 that is depicted in Figure 5.

The diffracted radiation receiving portion 64 comprises a series of annular recesses 72-74. The annular recesses 72-74 are irregularly spaced. Each annular recess 72-74 is configured to receive a particular order of diffracted infrared radiation, and to reflect that infrared radiation away from the exit opening 8 of the housing 9. As an example, a second annular recess 73 is configured to receive the first diffraction order of the radiation (this diffraction order has more power than other diffraction orders). The second annular recess 73 comprises a roof portion 76 which extends in a generally radial direction relative to the optical axis OA of the radiation source. The roof portion 76 is not necessarily flat and is not necessarily fully perpendicular to the optical axis (OA). Nevertheless, it extends in a generally radial direction. The roof portion is configured to receive and reflect the first diffracted order of the infrared radiation.

The second annular recess 73 further comprises an outwardly tapering wall portion 78. An upper end of the outwardly tapering wall portion 78 is connected to the roof portion 76. The connection between the wall portion 78 and the roof portion 76 is via a radiussed portion 80. The wall portion 78 is not configured to directly receive diffracted infrared radiation. The wall portion 78 connects the roof portion 76 (which is configured to receive diffracted infrared radiation) to an adjacent part 82 of the housing 9. The outward taper of the wall portion 78 may advantageously allow for a wider roof portion 76 than would be provided if there were no outward taper.

A non-recessed wall portion 82 extends from the annular recess 73 towards an adjacent annular recess 72. This wall portion 82 is configured to receive and reflect diffracted radiation which has been reflected from the roof portion 76.

Other annular recesses 72, 74 have a corresponding general construction.

The direct infrared radiation receiving portion 58 includes a portion 71 which receives direct infrared radiation in an 'off-droplet' situation and does not directly receive diffracted infrared radiation in an 'on-droplet' situation. This portion 71 comprises a series of steps, and for brevity may be referred to as the stepped portion 71. The stepped portion 71 extends beyond the bottom of Figure 5.

The stepped portion 71 is configured to reflect directly incident infrared radiation 2 to other portions of the housing 9 which are further away from the exit opening 8 (e.g. to the infrared radiation absorbing portion 60). The stepped portion 71 is also configured to reflect diffracted infrared radiation which has already been reflected from the diffracted radiation receiving portion 64 (e.g. to reflect that radiation further away from the exit opening 8).

The stepped portion 71 comprises a series of annular steps 90. The annular steps 90 may be generally equal in size. Each annular step 90 comprises an inwardly tapering portion 92 and an outwardly tapering portion 94 (one of each is labelled in Figure 5). The inwardly tapering portions 92 may subtend an angle of between 10° and 30° relative to a plane which is perpendicular to the optical axis OA. The angle of an inwardly tapering portion 92 may for example be between 17° and 20° with respect to that plane. The outwardly tapering portions 94 may for example subtend an angle of between 3° and 9° with respect to the optical axis OA. An outwardly tapering portion 94 may subtend an angle of between 4° and 6° relative to the optical axis OA.

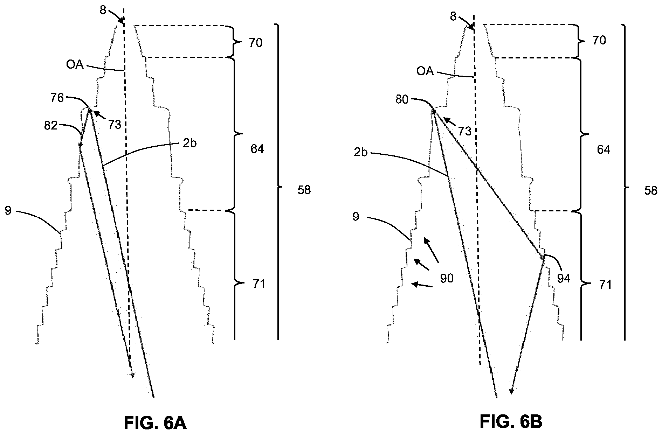

Figure 6A shows a ray of diffracted infrared radiation 2b which is incident upon the roof portion 76 of the second annular recess 73 of the diffracted radiation receiving portion 64. This is an on-droplet situation. As depicted, the diffracted infrared radiation 2b is reflected away from the exit opening 8 and towards the non-recessed wall portion 82. The reflected diffracted infrared radiation 2b is reflected by the non-recessed wall portion 82 with a grazing incidence angle. The reflected diffracted infrared radiation 2b travels away from the exit opening 8 and into the proximal portion 60 of the housing 9 (see Figures 3A and 3B) which is configured to absorb the infrared radiation (the proximal portion 60 may also be referred to as the infrared radiation absorbing portion). The non-recessed wall portion 82 which receives the reflected diffracted infrared radiation 2b is adjacent to the roof portion 76.

Other annular recesses 72, 74 of the diffracted radiation receiving portion 64 may reflect diffracted infrared radiation 2b from a roof portion in the same way.

Figure 6B shows diffracted infrared radiation 2b which is incident upon the radiussed portion 80 of the second annular recess 73 of the diffracted radiation receiving portion 64. This is also an on-droplet situation. As depicted, the diffracted infrared radiation 2b is reflected away from the exit opening 8, across the housing 9 and towards the stepped portion 71. The reflected diffracted infrared radiation 2b is reflected by an outwardly tapering portion 94 of an annular step 90. The reflected diffracted infrared radiation 2b travels away from the exit opening 8 and into the proximal portion 60 of the housing 9 (see Figures 3A and 3B) which is configured to absorb the infrared radiation.

Other annular recesses 72, 74 of the diffracted radiation receiving portion 64 may reflect diffracted infrared radiation 2b from a radiussed portion in the same way.

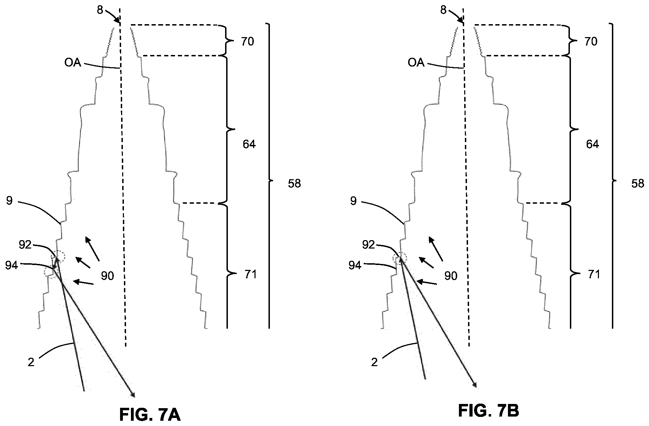

Figure 7A shows infrared radiation 2 which is directly incident at a step 90 of the stepped portion 71 of the housing 9. This is an off-droplet situation. The infrared radiation 2 is incident on an inwardly tapering portion 92 of the step 90. The infrared radiation is reflected from the inwardly tapering portion 92 of the step 90 away from the exit opening 8. This reflection is close to a normally incident reflection (it is not a grazing incidence reflection). The surface of the stepped portion 71 may include some roughness (see below), and as a result reflection of the infrared radiation may include some scattering. The infrared radiation is reflected from the inwardly tapering portion 92 of the step 90 towards an outwardly tapering portion 94 of the step. This reflected infrared radiation 2 undergoes a grazing incidence reflection at the outwardly tapering portion 94, and thus is strongly reflected from the outwardly tapering portion 94 in a specular manner. The reflected infrared radiation 2 travels away from the exit opening 8 and into the proximal portion 60 of the housing 9 (see Figures 3A and 3B) which is configured to absorb the infrared radiation.

Figure 7B also shows infrared radiation 2 which is directly incident at the same step 90 of the stepped portion 71 of the housing 9. This is also an off-droplet situation. The infrared radiation 2 is incident on the inwardly tapering portion 92 of the step 90. As noted above, the reflection of the infrared radiation 2 includes some scattering. This is depicted in Figure 7B by part of the reflected infrared radiation 2 passing across the housing 9. This scattered infrared radiation is also directed away from the exit opening 8.

The tip portion 70 of the housing 50 is provided with a sawtooth arrangement. This sawtooth arrangement is used in preference to other structures because there is very limited space available for any structure in the tip portion 70, and a sawtooth arrangement takes up only a small amount of space. The sawtooth arrangement prevents or reduces reflection of infrared radiation out of the exit opening 8.

The diffracted radiation receiving portion 64 and the tip portion 70 of the housing 9 may be formed from copper. The copper may be provided with a milled or polished surface. Milled or polished copper is reflective for infrared radiation (e.g. reflects 95% or more of incident infrared radiation). Other reflective materials may be used (e.g. other metals). The reflective material may be milled or polished. In general, a reflective portion of the housing may reflect more than 50% of incident infrared radiation, e.g. reflects 95% or more of incident infrared radiation. The diffracted radiation receiving portion 64 may be configured to provide reflection of infrared radiation without significant scattering (e.g. less than 5% of reflected infrared radiation is scattered). The tip portion 70 may be configured to provide reflection of infrared radiation without significant scattering (e.g. less than 5% of reflected infrared radiation is scattered).

In an embodiment, the stepped portion 71 of the housing 9 may also be formed from copper (or other reflective material such as other metal). The stepped portion 71 may be provided with a greater roughness than polished copper. For example, the greater roughness may be achieved by providing a coating on the copper. In one example, a tungsten coating maybe provided. The greater roughness provides some scattering of infrared radiation which is incident at non-grazing angles of incidence (e.g. close to a normal angle of incidence). The root mean square (rms) surface roughness may be of the same order as the wavelength being scattered (e.g. 10 microns for a 10 micron laser beam). The rms surface roughness may be at least 1 micron. When the rms roughness is of the same order as the wavelength of incident radiation, then scattering of more than 95% of incident radiation may occur.

Directly incident infrared radiation 2 in an off-droplet situation may have a relatively high power. Scattering of this directly incident infrared radiation 2 may advantageously distribute the infrared radiation 9, thereby reducing the likelihood that hotspots of reflected infrared radiation are created. An example of the scattering is described above in connection with Figure 7B.

In general, the stepped portion 71 of the housing 9 may have a greater roughness than the diffracted radiation receiving portion 64 (e.g. greater by at least a factor of 10). The diffracted radiation receiving portion 64 may have a rms roughness of less than 1 micron. The stepped portion 71 may have a rms roughness of 10 microns or more.

The proximal portion 60 of the housing 9 (see Figures 3A and 3B) may be configured to absorb infrared radiation (e.g. reflect less than 50% of the incident infrared radiation). This portion may be provided with a coating which provides a greater roughness than polished copper. The proximal portion 60 of the housing 9 may have a greater roughness than the diffracted radiation receiving portion 64 (e.g. greater by at least a factor of 10). The diffracted radiation receiving portion 64 may have a rms roughness of less than 1 micron. The proximal portion 60 may have a rms roughness of 10 microns or more. In one example, a tungsten coating maybe provided. The tungsten coating may be thicker than a tungsten coating provided on the stepped portion 71. Providing a surface with a greater roughness in the proximal housing portion 60 is advantageous because infrared radiation which is not absorbed is scattered rather than undergoing specular reflection. This scattering acts to diffuse the infrared radiation such that it may be spread more equally around the proximal portion 60. This advantageously reduces the likelihood that a particular location on the proximal portion 64 is excessively heated by a strong reflected beam of infrared radiation.

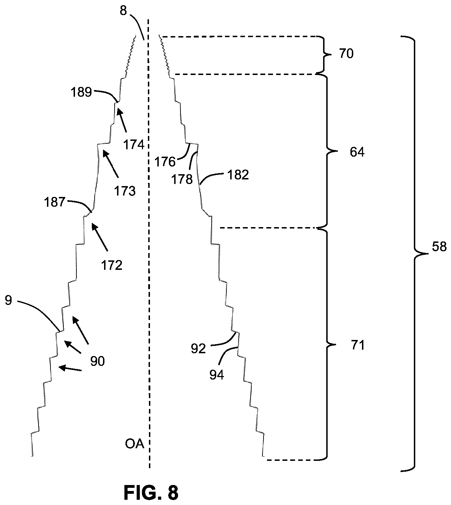

Another embodiment is depicted in Figure 8. This embodiment generally corresponds with the embodiment depicted in Figure 5, and for this reason not all features are described again. The housing 9 has a tip portion 70 and a stepped portion 71 which generally correspond with the embodiment depicted in Figure 5. However, the diffracted radiation receiving portion 64 differs from the embodiment depicted in Figure 5. In the embodiment of Figure 8 the diffracted radiation receiving portion 64 comprises a series of annular recesses 172-174 which are irregularly spaced. The annular recesses 172-174 are configured to each receive a particular diffraction order of diffracted infrared radiation, and to reflect that infrared radiation away from the exit opening 8 of the housing 9.

As an example, a second annular recess 173 is configured to receive the first diffraction order of the radiation. As with the embodiment of Figure 5, the second annular recess 173 comprises a roof portion 176 which extends in a generally radial direction relative to the optical axis OA of the radiation source. The roof portion 176 is not necessarily flat and is not necessarily fully perpendicular to the optical axis (OA). Nevertheless, it extends in a generally radial direction. The roof portion176 is configured to receive and reflect the first diffracted order of the infrared radiation.

The second annular recess 173 further comprises an outwardly tapering wall portion 178. An upper end of the outwardly tapering wall portion 78 is connected to the roof portion 176. The connection between the wall portion 78 and the roof portion 76 is via a corner 180. The corner 180 is not a radiussed corner as is the case in the Figure 5 embodiment, but instead is an angled corner. In practice due to manufacturing tolerances the corner 180 may include a small radius, but this is very small (e.g. 2mm or less). The wall portion 178 is not configured to directly receive diffracted infrared radiation. The wall portion 178 connects the roof portion 176 (which is configured to receive diffracted infrared radiation) to an adjacent part 182 of the housing 9. The outward taper of the wall portion 178 may advantageously allow for a wider roof portion 76 than would be provided if there were no outward taper.

A non-recessed wall portion 182 extends from the annular recess 173 towards an adjacent annular recess 172. This wall portion 182 is configured to receive and reflect diffracted radiation which has been reflected from the roof portion 176.

The second annular recess 173 functions in the same manner as described further above in connection with the embodiment depicted in Figure 5.

The first annular recess 172 and the third annular recess 174 have a construction which differs from the second annular recess 173 in that they include roof portions 187, 189 which have a substantial component in the direction of the optical axis OA. That is, the roof portions taper inwardly. These roof portions 187, 189 function in a different way to the generally radial roof portions. The roof portions 187, 189 act to reflect incident diffracted infrared radiation across the housing 9 to an opposite side of the housing. In common with other roof portions, the reflection provided by the roof portions 187, 189 directs the infrared radiation away from the exit opening 8.

The radiussed corners of the first embodiment may be easier to manufacture than the angled corner of the second embodiment.

Embodiments of the invention may reflect infrared radiation away from the distal portion 58 of the housing 9, and in particular the diffracted radiation receiving portion 64. This is advantageous because heating of the distal portion 58 (in particular the diffracted radiation receiving portion), which can occur due to absorption of infrared radiation, could cause distortion of the distal portion and could thereby cause the position of the exit opening 8 to move. If this were to happen, then part of the EUV radiation beam B could be obscured by the exit opening. Active cooling (e.g. water cooling) may be provided to the distal portion 58 of the housing 9. However, it may be difficult to provide fully effective cooling of the distal portion 58 because it has a relatively small surface area.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrates) or mask (or other patterning devices). These apparatus may be generally referred to as lithographic tools. Such a lithographic tool may use vacuum conditions or ambient (non-vacuum) conditions.

The lithographic apparatus LA and radiation source SO described herein can be used in a method for manufacturing a semiconductor device. A semiconductor device manufacturing method comprises receiving a substrate W with a photoresist layer. The method further comprises directing a radiation beam from radiation source SO to transfer a pattern from a mask onto the photoresist layer. This could be achieved by a patterning device which is configured to form a patterned radiation beam, imparting the patterned radiation beam onto the photoresist layer. The method for manufacturing a semiconductor device further comprises the step of removing a portion of the photoresist layer to form the pattern over the substrate W.

The substrate W may be made of silicon or other semiconductor materials. Alternatively or additionally, the substrate W may include other semiconductor materials such as germanium (Ge) or carbon (C). In some embodiments, the semiconductor substrate is made of a compound semiconductor such as III-V compound semiconductors, II-V compound semiconductors, and/or any suitable integration of Group IV materials. In some embodiments, the substrate W may be a silicon-on-insulator (SOI) or a germanium-on-insulator (GOI) substrate.

The semiconductor device made from the substrate W may have various device elements. Examples of semiconductor device elements that are formed over the substrate W include transistors (e.g., planar or non-planar metal oxide semiconductor field effect transistors (MOSFET), bipolar junction transistors (BJT), high-voltage transistors, high-frequency transistors, etc.), diodes, CMOS image sensors, passive devices, and/or other applicable elements. Various processes may be performed to form the semiconductor device elements, such as deposition, etching, implantation, epitaxial growth, polishing, thermal treatment, and/or other suitable processes. In some embodiments, the substrate W is coated with a photoresist layer sensitive to the EUV light.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical, and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A radiation source comprising a source of target material configured to direct target material to a plasma formation location, and a laser system configured to direct an infrared laser beam onto the target material at the plasma formation location to generate EUV radiation, wherein the radiation source further comprises a housing with an opening through which EUV radiation may exit the radiation source, wherein the radiation source is configured such that a first portion of the housing receives a majority of the infrared radiation beam when the infrared radiation beam is not incident upon a target material, and wherein the first portion of the housing is configured to reflect the infrared radiation to other portions of the housing which are further away from the opening of the housing.

2. The radiation source of claim 1, wherein the first portion of the housing is configured to receive substantially all of the infrared radiation beam when the infrared radiation beam is not incident upon a target material.

3. The radiation source of claim 1 or claim 2, wherein the first portion of the housing comprises a series of annular steps which comprise an inwardly tapering portion and an outwardly tapering portion.

4. The radiation source of claim 3, wherein the inwardly tapering portion subtends an angle of between 10° and 30° relative to a plane which is perpendicular to an optical axis of the radiation source.

5. The radiation source of claim 3 or claim 4, wherein the outwardly tapering portion subtends an angle of between 3° and 9° relative to an optical axis of the radiation source.

6. The radiation source of any of claims 3 to 5, wherein the annular steps are generally equal in size.

7. The radiation source of any preceding claim, wherein the first portion of the housing has a surface roughness which is less than the surface roughness of other portions of the housing.

8. A radiation source housing and collector, the collector being configured to collect EUV radiation emitted from a plasma formation location and direct the EUV radiation to an opening of the housing, wherein the collector is configured to receive infrared radiation from the plasma formation location and diffract the infrared radiation towards a diffracted radiation receiving portion of the housing, and wherein the diffracted radiation receiving portion of the housing comprises a series of irregularly spaced annular recesses.

9. The radiation source housing and collector of claim 8, wherein the irregularly annular spaced annular recesses of the diffracted radiation receiving portion of the housing are each configured to receive different orders of diffracted infrared radiation, and to reflect the diffracted infrared radiation away from the opening of the housing.

10. The radiation source housing and collector of claim 8 or claim 9, wherein at least one of the annular recesses comprises a roof portion which extends in a generally radial direction relative to an optical axis of the radiation source.

11. The radiation source housing and collector of any of claims 8 to 10, wherein the annular recesses further comprise an outwardly tapering wall portion.

12. The radiation source housing and collector of any of claims 8 to 11, wherein a non-recessed wall portion extends between adjacent annular recesses.

13. The radiation source housing and collector of any of claims 8 to 12, wherein the diffracted radiation receiving portion of the housing has a surface roughness which is less than the surface roughness of other portions of the housing.

14. A radiation source according to claim 1 and further comprising the radiation source housing and collector of claim 8, wherein the diffracted radiation receiving portion of the housing forms part of the first portion of the housing.

15. The radiation source of claim 14, wherein a portion of the housing which is further away from the exit opening than the diffracted radiation receiving portion of the housing has a rougher surface than the diffracted radiation receiving portion.

16. The radiation source of claim 14 or claim 15, wherein the radiation source is frustoconical.

17. The radiation source of any of claims 14 to 16, and further comprising a source of target material configured to direct target material to the plasma formation location, and a laser system configured to direct a laser beam onto the target material at the plasma formation location.

18. An exposure apparatus comprising the radiation source of claim 15, and further comprising in an illumination system configured to receive EUV radiation which passes out of the opening of the radiation source housing, and further comprising a projection system configured to project patterned EUV radiation onto a substrate.

19. A method of manufacturing/forming a semiconductor device comprising the steps of receiving a substrate with a photoresist layer, directing onto the substrate radiation from a radiation source according to claim 1 or a radiation source comprising the housing and collector of claim 7, to transfer a pattern from a mask onto the photoresist layer, and removing a portion of the photoresist layer to form the pattern over the substrate.
